# FASCICULE DE BREVET EUROPEEN

(11) **EP 3 055 249 B1**
(45) Date de publication et mention de la délivrance du brevet: **29.11.2017**
(21) Numéro de dépôt: 14787234.5
(22) Date de dépôt: 02.10.2014
(51) Int. Cl.: B81C 1/00, H01M 6/40, H01M 10/04, H01M 10/02

(54) **SUBSTRAT MICROSTRUCTURE**
MIKROSTRUKTURIERTES SUBSTRAT
MICROSTRUCTURED SUBSTRATE

(30) Priorité: 07.10.2013 FR 1359717
(43) Date de publication de la demande: 17.08.2016
(73) Titulaire: Centre National de la Recherche Scientifique, 75016 Paris (FR); Universite de Nantes, 44000 Nantes (FR)
(72) Inventeur: LETHIEN, Christophe, 62138 Violaines (FR); TILMANT, Pascal, 59160 Lomme (FR); EUSTACHE, Etienne, 59800 Lille (FR); ROLLAND, Nathalie, 59650 Villeneuve D'Ascq (FR); BROUSSE, Thierry, 44240 La Chapelle sur Erdre (FR)
(74) Mandataire: Goulard, Sophie
(86) Numéro de dépôt international: PCT/FR2014/052505
(87) Numéro de publication internationale: WO 2015/052412

(56) Documents cités:
- WO-A1-2011/121166
- WO-A2-2008/056190
- US-A1- 2004 171 274
- US-A1- 2007 128 875
- US-A1- 2010 213 579
- US-A1- 2011 033 974
- US-A1- 2013 071 751
- US-A1- 2013 149 605

## Description

La présente invention concerne un substrat microstructuré comportant une pluralité d'au moins une microstructure élémentaire et le procédé de fabrication dudit substrat microstructuré.

La présente invention concerne également l'utilisation d'un tel substrat pour la fabrication d'un dispositif de stockage d'énergie électrique comportant le substrat microstructuré selon l'invention. Le substrat microstructuré selon l'invention est par exemple particulièrement avantageux dans la fabrication de batteries électrochimiques (telles que des batteries tout solide), ou de condensateurs (tels que des condensateurs électrostatiques, des condensateurs électrolytiques, des super-condensateurs...). Le substrat microstructuré selon l'invention est de plus particulièrement avantageux en ce qui concerne la fabrication de dispositifs de stockage d'énergie électrique de taille micrométrique (c'est-à-dire entre 10⁻⁶ et 10⁻³m) voire millimétrique ou centimétrique pouvant par exemple être disposés sur un circuit intégré.

Les substrats sont par exemple réalisés dans des matériaux semi-conducteurs ou diélectriques et se présentent généralement sous forme de disque fin (aussi appelé wafer) qui serviront de support pour la fabrication de microstructures et/ou de systèmes de tailles micrométriques ou nanométriques.

Ces microstructures peuvent par exemple être fabriquées par l'une ou plusieurs des techniques suivantes : la gravure chimique ou physique, la croissance de nano/micro structures, le dépôt électrolytique de matériaux à l'intérieur de moules micro/nanométriques suivi de la dissolution du moule...

En effet, initialement un substrat présente une surface plane correspondant à une topologie à deux dimensions. Mais, en fonction de la destination du substrat, il peut s'avérer avantageux de microstructurer la surface du substrat pour que celle-ci présente une topologie à trois dimensions.

Ainsi, un substrat microstructuré présente une surface spécifique plus importante qu'un substrat plan (c'est-à-dire non microstructuré).

La surface d'un substrat peut par exemple être augmentée par la disposition de microstructures présentant un rapport d'aspect élevé à la surface dudit substrat. Le rapport d'aspect d'une microstructure correspond par exemple au rapport de sa dimension longitudinale par sa plus petite dimension transversale (par exemple la plus petite distance transversale entre deux microstructures disposées consécutivement sur le substrat).

En effet, un substrat microstructuré permet par exemple le dépôt d'une plus grande quantité de matériaux à sa surface et plus particulièrement sur les surfaces latérales des microstructures.

Cela peut par exemple améliorer les performances d'un dispositif de stockage d'énergie électrique, augmenter le nombre de composants intégrables sur un substrat, etc.

Il existe donc un besoin pour des substrats structurés présentant une surface spécifique améliorée par rapport aux substrats structurés de l'art antérieur, car la surface spécifique influe par exemple sur les performances des batteries tout solide.

Des microstructures du type tranchées, piliers et canaux sont connues, mais présentent les inconvénients d'être mécaniquement fragiles et/ou de ne pas suffisamment augmenter la surface du substrat par rapport à la surface d'un substrat plan.

Le document US 2013/071751 A1 décrit un substrat microstructuré comportant une pluralité de microstructures élémentaires de forme tubulaire avec des extrémités inférieure et supérieure longitudinales opposées, les microstructures élémentaires définissant une cavité interne ouverte au niveau de leur extrémité supérieure. La présente invention a donc pour premier objet un nouveau type de substrat microstructuré comportant une pluralité d'au moins une microstructure élémentaire, ladite au moins une microstructure élémentaire présentant une forme tubulaire avec des extrémités inférieure et supérieure longitudinales opposées, l'extrémité inférieure étant reliée au substrat, ladite au moins une microstructure élémentaire définissant une cavité interne ouverte au niveau de son extrémité supérieure, ledit substrat microstructuré étant caractérisé en ce qu'il comporte une couche conforme d'alumine déposée à sa surface, à l'intérieur et à l'extérieur des microstructures élémentaires. Cette couche d'alumine comble au moins partiellement les stries produites par le procédé d'obtention du substrat microstructuré selon l'invention afin de faciliter le dépôt ultérieur d'autres matériaux à la surface du substrat microstructuré et d'isoler électriquement le substrat microstructuré selon l'invention.

La cavité ouverte au niveau de l'extrémité supérieure de la microstructure élémentaire permet d'augmenter la surface du substrat. On note que la surface du substrat est augmentée de manière plus importante qu'avec des microstructures de l'art antérieur qui se présentent sous la forme de fils ou de piliers.

Selon une caractéristique possible, la microstructure élémentaire présente une section transversale circulaire, elliptique, rectangulaire, carré ou triangulaire.

On notera que la microstructure à section rectangulaire et plus particulièrement carrée est avantageuse, car celle-ci augmente la surface du substrat de façon plus importante que les microstructures présentant une section d'un autre type à dimensions équivalentes (c'est-à-dire pour des valeurs identiques d'extensions spatiales longitudinale et transversale).

Selon une autre caractéristique possible, la microstructure élémentaire présente une dimension longitudinale comprise entre environ 5 et 200 µm (ou micromètres), la dimension longitudinale étant de préférence comprise entre 50 et 100 µm, et une dimension transversale comprise entre environ 2 et 10 µm.

Selon une autre caractéristique possible, les microstructures élémentaires du substrat sont disposées périodiquement sur ledit substrat.

Selon une autre caractéristique possible, les microstructures élémentaires du substrat présentent une période spatiale SP comprise entre 3 et 10 µm.

Selon une autre caractéristique possible, deux microstructures élémentaires du substrat disposées consécutivement sont espacées l'une de l'autre d'une distance comprise entre environ 0,5 et 10 µm et de préférence comprise entre 0,5 et 2 µm.

Selon une autre caractéristique possible, la cavité ouverte de chacune des microstructures élémentaires s'étend longitudinalement à l'intérieur de ladite microstructure élémentaire.

Ainsi, les microstructures élémentaires présentent sensiblement la forme d'un microtube (ou encore la forme d'un micropilier au moins partiellement évidé selon sa longueur).

L'extension longitudinale de la cavité permet d'augmenter la surface du substrat microstructuré.

Selon une autre caractéristique possible, la microstructure élémentaire présente un rapport d'aspect supérieur ou égal à 10 et de préférence compris entre 10 et 100.

Selon une autre caractéristique possible, le substrat microstructuré est réalisé dans un matériau choisi parmi le silicium, le dioxyde de silicium, l'arséniure de gallium, le nitrure de silicium et le phosphure d'indium.

Selon une autre caractéristique possible, lesdites microstructures élémentaires sont réalisées en silicium.

Selon une autre caractéristique possible, le substrat microstructuré et la pluralité de microstructures élémentaires sont réalisés d'une seule pièce (c'est-à-dire que le substrat microstructuré et la pluralité de microstructures élémentaires forment un élément monobloc d'un même matériau), par exemple en silicium.

La présente invention a pour deuxième objet un procédé d'obtention d'un substrat microstructuré tel que défini précédemment par microstructuration d'un substrat comportant une surface plane, caractérisé en ce qu'il comporte au moins les étapes suivantes :
a) une étape d'enduction d'une couche de résine photosensible sur la surface plane dudit substrat ;
b) une étape de réalisation, par photolithographie, d'une répétition d'au moins un motif élémentaire de forme annulaire dans la couche de résine photosensible afin que la surface du substrat présente des zones exemptes de résine photosensible ;
c) une étape de gravure des zones de la surface du substrat exemptes de résine photosensible, les zones recouvertes de résine photosensible étant quant à elles protégées ;
d) une étape de passivation de la surface du substrat ;
e) une étape de répétition des étapes de gravure c) et de passivation d) afin d'obtenir ledit substrat microstructuré, et, postérieurement à l'étape de répétition e), une étape de dépôt d'une couche conforme d'alumine à la surface du substrat microstructuré, à l'intérieur et à l'extérieur des microstructures élémentaires.
Selon une caractéristique possible, les étapes de gravure et de passivation sont réalisées par l'intermédiaire de gaz ionisés.

Pour l'étape de photolithographie, le motif élémentaire jouant le rôle de masque pendant l'étape de gravure présente avantageusement une forme annulaire dont les dimensions (diamètres extérieur et intérieur) coïncident avec la section et les dimensions transversales SP, FP et ID de la microstructure élémentaire : il aura ainsi une forme annulaire circulaire afin d'obtenir des microtubes à section circulaire après l'étape de gravure, ou une forme annulaire carrée afin d'obtenir des microtubes à section carrée. Par le terme « annulaire » il est entendu toute forme géométrique trouée en son centre.

Ainsi, le motif élémentaire obtenu lors de l'étape de photolithographie b) peut présenter une forme annulaire dont les dimensions coïncident avec les dimensions transversales SP, FP, ID de la microstructure élémentaire.

Pour l'étape de gravure, le gaz ionisé est de préférence choisi parmi les gaz ionisés suivants : le tétrafluorure de carbone, l'hexafluorure de soufre, le méthane, le dihydrogène, le dichlore, le bromure d'hydrogène, le trichlorure de bore, le tétrachlorure de silicium et l'un de leurs mélanges.

Pour l'étape de passivation, le gaz ionisé est par exemple de l'octafluorocyclobutane.

Le dépôt conforme d'une couche d'alumine permet entre autres d'isoler électriquement le substrat microstructuré et de réduire les aspérités à la surface des microstructures.

La présente invention concerne également l'utilisation d'un substrat structuré tel que défini précédemment pour l'élaboration d'un dispositif de stockage d'énergie électrique et plus particulièrement d'une batterie électrochimique tout solide.

Ainsi, la présente invention a aussi pour objet un dispositif de stockage d'énergie électrique comportant un substrat microstructuré selon l'invention.

En effet, les substrats peuvent par exemple servir de support à la fabrication d'une batterie tout solide. Une batterie tout solide est une batterie dans laquelle les électrodes et l'électrolyte sont des composés solides.

Il est alors avantageux que le substrat soit microstructuré de manière à optimiser le fonctionnement de la batterie tout solide dont elle est le support.

A cet effet, l'invention concerne un dispositif de stockage d'énergie électrique comportant au moins :
- un substrat,
- une électrode négative et une électrode positive dont l'une est disposée sur le substrat,
- un électrolyte disposé entre l'électrode négative et l'électrode positive,
caractérisé en ce que le substrat est un substrat microstructuré tel que défini précédemment.

On note qu'en fonction des matériaux d'électrodes, la batterie électrique peut comporter un ou plusieurs collecteurs de courant.

Le dispositif peut comprendre en outre un premier collecteur de courant disposé sur le substrat, un deuxième collecteur de courant, l'électrode négative et l'électrode positive étant disposées entre les premier et deuxième collecteurs de courant.

Le substrat peut être réalisé dans un matériau choisi parmi le silicium, le dioxyde de silicium, l'arséniure de gallium, le nitrure de silicium et le phosphure d'indium et les collecteurs de courant peuvent être réalisés dans des matériaux solides choisis parmi l'aluminium, le cuivre, le platine et le nitrure de titane.

Selon une autre caractéristique possible, les matériaux d'électrode négative sont choisis parmi le carbone (par exemple sous forme graphite), le dioxyde de titane (ou TiO₂), le titanate de lithium (ou Li₄Ti₅O₁₂), le silicium (ou Si), le germanium (ou Ge), les métaux de transition (Au, Ag, Pt...).

Selon une autre caractéristique possible, les matériaux d'électrode positive sont choisis parmi les oxydes lamellaires de lithium et de métaux de transition, les spinelles de lithium, les composés chimiques de formule générale LiMPO₄ (M représentant au moins un élément choisi parmi les métaux de transition), les composés polyanioniques tels que les fluorosulfates, les fluorophosphates de lithium et de métaux de transition, les sulfates de lithium et de métaux de transition.

Selon une autre caractéristique possible, l'électrolyte comprend un sel de lithium choisi parmi l'orthophosphate de lithium (ou Li₃PO₄), l'oxynitrure de lithium et de phosphore (ou LiPON), les titanates de lithium et/ou de lanthane, le bis(oxalato)borate de lithium (ou LiBOB), le bis(trifluoro-méthanesulfonyl)imidure de lithium (ou LiTFSI) en solution dans un solvant.

Selon une autre caractéristique possible, lesdits collecteurs de courant sont réalisés dans des matériaux solides tels que l'aluminium, le cuivre, le platine, le nitrure de titane.

Selon une autre caractéristique possible, l'électrode négative, l'électrode positive et l'électrolyte se présentent chacun sous la forme d'une couche mince.

Les électrodes négative et positive ainsi que l'électrolyte présentent chacun une épaisseur comprise entre 15 et 200 nm (ou nanomètres).

Selon une autre caractéristique possible, lesdits au moins deux collecteurs de courant se présentent chacun sous la forme d'une couche mince ayant une épaisseur comprise entre 25 et 50 nm.

L'invention sera mieux comprise, et d'autres buts, détails, caractéristiques et avantages de celles-ci apparaîtront plus clairement au cours de la description suivante de modes et d'exemples de réalisation particuliers de l'invention, donnée uniquement à titre illustratif et non limitatif, en référence aux dessins annexés :
- la figure la représente une vue très schématique en coupe longitudinale d'un substrat microstructuré selon l'invention ;
- la figure 1b est une vue de haut du substrat microstructuré de la figure la ;
- la figure 1c est une vue de haut agrandie de deux types de microstructures élémentaires disposées sur le substrat microstructuré de la figure la ;
- la figure 1d est une photographie en coupe d'une partie d'un substrat microstructuré selon l'invention ;
- les figures 2a, 2b, 3a et 3b sont des photographies des motifs obtenus lors de l'étape de photolithographie selon l'invention ;
- les figures 4a à 4c sont des photographies à différents grossissements d'un substrat microstructuré selon l'invention ;
- la figure 5a représente une vue schématique de haut, en perspective et partiellement arrachée d'un dispositif de stockage d'énergie électrique selon l'invention ;
- la figure 5b est une vue schématique en coupe transversale et agrandie des éléments constitutifs dudit dispositif de stockage d'énergie électrique de la figure 5a ;
- les figures 6a à 6d représentent des graphiques illustrant les performances d'une batterie selon l'invention.

La figure la représente une vue très schématique en coupe longitudinale d'un substrat microstructuré 1 selon l'invention comportant une pluralité de microstructures élémentaires 3.

Le substrat est, dans le mode de réalisation présenté, un wafer de silicium qui présente une surface sensiblement plane et une épaisseur sensiblement constante.

Ladite microstructure élémentaire 3 présente une forme allongée et deux extrémités inférieure 3a et supérieure 3b longitudinales opposées.

La microstructure élémentaire 3 est reliée au substrat 1 par l'intermédiaire de son extrémité inférieure 3a et s'étend en éloignement de la surface dudit substrat 1. L'extrémité supérieure 3b de la microstructure élémentaire 3 est libre. De plus, l'axe longitudinal de ladite microstructure élémentaire 3 est sensiblement orthogonal au plan d'extension principal dudit substrat 1.

Par ailleurs, la microstructure élémentaire 3 comporte une cavité 5 ouverte au niveau de l'extrémité supérieure 3b de ladite microstructure 3.

On note que la microstructure élémentaire 3 présente une face externe 3c qui délimite le contour extérieur de la microstructure 3 et une face interne 3d qui délimite ladite cavité 5.

Plus particulièrement, la cavité 5 ouverte s'étend longitudinalement à l'intérieur de ladite microstructure élémentaire 3. La cavité 5 est caractérisée par une dimension longitudinale dᵢₙ comprise entre 5 et 50 µm. La microstructure élémentaire 3 est caractérisée par une distance entre l'extrémité inférieure et supérieure de la microstructure élémentaire qui correspond à la dimension longitudinale d_{L} de la microstructure élémentaire 3. La dimension longitudinale d_{L} de la microstructure élémentaire est comprise entre 10 et 200 µm.

On note que la dimension longitudinale dᵢₙ de la cavité 5 est sensiblement égale à la moitié de la dimension longitudinale d_{L} de la microstructure élémentaire 3.

La microstructure élémentaire 3 est aussi caractérisée par une dimension transversale OD qui correspond à l'extension spatiale maximale de la microstructure élémentaire 3 dans un plan orthogonal à l'axe longitudinal de ladite microstructure 3. La dimension transversale OD de la microstructure élémentaire est comprise entre 2 et 10 µm.

On note que lesdites microstructures élémentaires 3 sont disposées, d'une part, de manière sensiblement parallèle les unes par rapport aux autres et, d'autre part, de manière à former par rapport au plan d'extension principal du substrat 1 un angle β sensiblement droit.

On entend par un angle sensiblement droit, un angle compris entre environ 88° et 92°.

Lesdites microstructures 3 sont espacées les unes des autres par une distance FP comprise entre environ 0,5 et 10 µm et de préférence comprise entre 1 et 2 µm.

On note de plus que la microstructure élémentaire peut par exemple présenter une section transversale circulaire, elliptique, rectangulaire, carrée ou triangulaire.

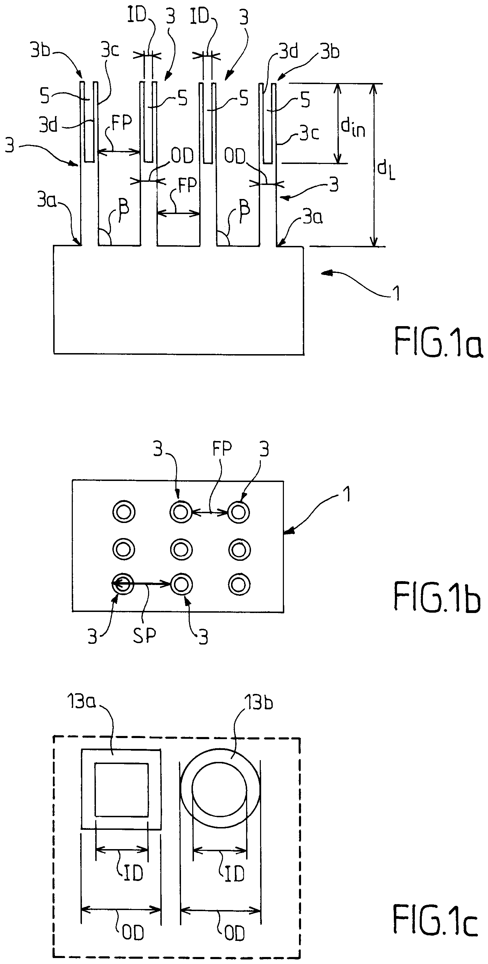

Comme illustré à la figure 1b, lesdites microstructures élémentaires 3 sont disposées périodiquement sur le substrat 1. La période spatiale SP des microstructures élémentaires 3 est par exemple comprise entre 3 et 10 µm.

La période spatiale SP est aussi égale à la somme de la dimension transversale OD d'une microstructure 3 et de l'espace (correspondant à la distance FP) séparant deux microstructures 3 disposées consécutivement.

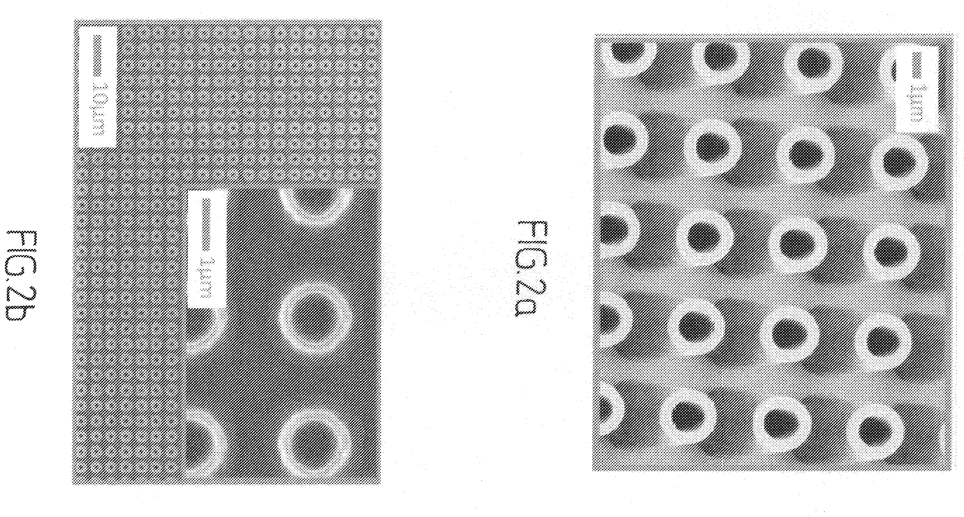

La figure 2 quant à elle est une vue schématique de haut de microstructures élémentaires 13a, 13b présentant des sections transversales respectivement carrée et circulaire.

Ainsi, chacune des microstructures élémentaires 3, 13a, 13b est aussi caractérisée par une dimension transversale ID correspondant à l'extension spatiale transversale ID maximale de la cavité 5 de la microstructure élémentaire 3.

La microstructure élémentaire peut ainsi être définie par un rapport d'aspect rₐₛₚ qui est le rapport de la dimension longitudinale d_{L} par la distance FP séparant deux microstructures élémentaires 3 consécutives. Le rapport d'aspect d'une microstructure élémentaire 3, 13a, 13b est par exemple supérieur ou égal à 10 et est de préférence compris entre 10 et 100.

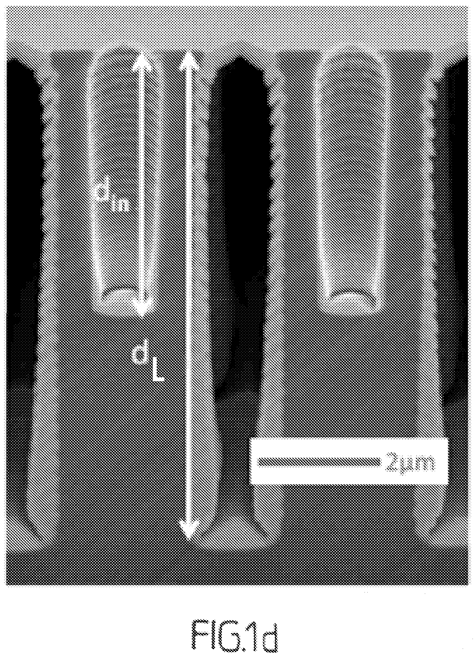

La figure 1d est une photographie en coupe d'un substrat microstructuré 1 selon l'invention qui comporte deux microstructures élémentaires 3. La figure 1d est une photographie prise par un microscope électronique à balayage vendu sous la dénomination commerciale Zeiss Ultra 55®.

Les microstructures élémentaires 3 de la figure 1d présentent les grandeurs caractéristiques suivantes :
- une dimension longitudinale d_{L} de 10 µm ;
- une dimension transversale OD de 3 µm ;
- une dimension longitudinale dᵢₙ de la cavité 5 de 5 µm ;
- une dimension transversale ID de la cavité 5 de 1 µm ;
- une période spatiale SP de 4 µm (on note donc que la distance FP séparant deux microstructures disposées consécutivement est de 1 µm).

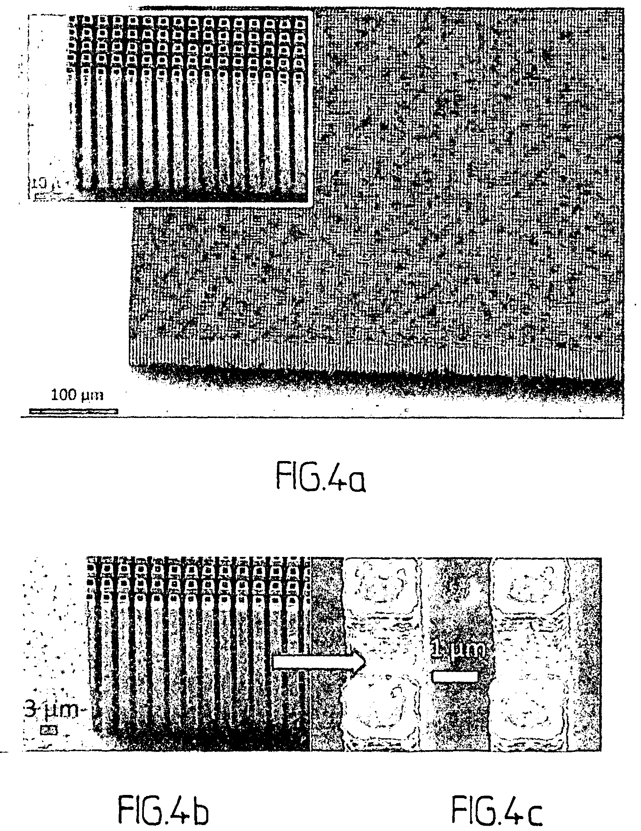

Les figures 4a à 4d annexées sont des photographies d'observation à différents grossissements d'un substrat microstructuré selon l'invention. Les photographies des figures 4a à 4d ont été observées par un microscope électronique à balayage vendu sous la dénomination commerciale Zeiss Ultra 55®.

On peut observer des microstructures élémentaires à section carrée disposées périodiquement sur un substrat de silicium.

Les grandeurs caractéristiques du substrat microstructuré des figures 4a à 4d sont les suivantes :
- une dimension longitudinale d_{L} de 30 µm ;
- une dimension transversale OD de 2 µm ;
- une dimension longitudinale dᵢₙ de la cavité 5 de 15 µm ;
- une dimension transversale ID de la cavité 5 de 1,2 µm ;
- une période spatiale SP de 4 µm (on note donc que la distance FP séparant deux microstructures disposées consécutivement est de 2 µm).

On note que le substrat microstructuré et ses microstructures peuvent aussi être réalisés dans un matériau choisi parmi le dioxyde de silicium, l'arséniure de gallium, le nitrure de silicium, le phosphure d'indium.

Le substrat microstructuré et la pluralité de microstructures élémentaires sont réalisés d'une seule pièce (c'est-à-dire que le substrat microstructuré et la pluralité de microstructures élémentaire forment un élément monobloc d'un même matériau).

Néanmoins, dans une variante de réalisation, le substrat et les microstructures peuvent être réalisés dans des matériaux différents.

On notera de plus que dans une autre variante de réalisation, la microstructure élémentaire est réalisée dans un matériau choisi parmi le dioxyde de silicium, l'arséniure de gallium, le phosphure d'indium et l'un de leurs mélanges.

Le substrat microstructuré 1 selon l'invention est obtenu par un procédé d'obtention qui est décrit ci-après.

Le procédé d'obtention d'un substrat microstructuré selon l'invention comporte les étapes suivantes :
a) Une étape de nettoyage d'un substrat ou wafer de silicium par des méthodes connues en soi et qui ne seront donc pas davantage détaillées ici.
b) Une étape d'enduction d'une couche de résine photosensible d'épaisseur uniforme sur la surface plane du wafer de silicium. Plus particulièrement, la couche de résine photosensible est déposée par enduction centrifuge (ou spin-coating). A titre d'exemple, on peut notamment utiliser la résine photosensible commercialisée sous la dénomination SPR® 220 par la société Rohm and Haas® ou la résine photosensible commercialisée sous la dénomination AZ9260® par la société Microchemicals GmbH.
c) Une étape de réalisation par photolithographie d'une répétition d'au moins un motif élémentaire dans la couche de résine photosensible afin que la surface du substrat présente des zones exemptes de résine photosensible. L'étape de réalisation par photolithographie d'une pluralité d'au moins un motif élémentaire est une méthode connue en soi et ne sera donc pas davantage détaillée ici.

Les figures 2a à 3b annexées sont des photographies obtenues par un microscope électronique à balayage Zeiss Ultra 55® sur lesquelles on peut observer une pluralité de motifs élémentaires réalisée en résine photosensible.

Les motifs élémentaires des figures 2a et 2b présentent sensiblement une forme de tube à section circulaire.

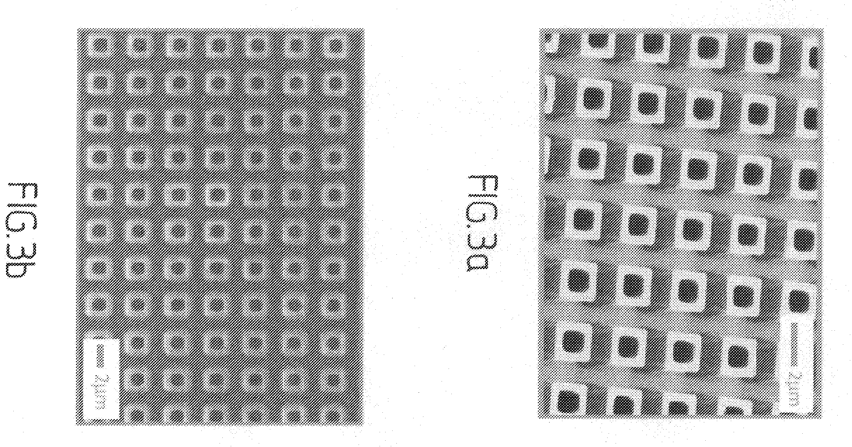

Les motifs élémentaires des figures 3a et 3b présentent sensiblement une forme de tube à section carrée.
d) Une étape de gravure des zones du substrat exemptes de résine photosensible. L'étape de gravure est effectuée par la technique de gravure ionique réactive profonde (ou DRIE) du type Bosch à l'aide d'un gaz ionisé tel que l'hexafluorure de soufre (ou SF₆). Le substrat de silicium est gravé à une vitesse de 3 µm par minute et la durée de l'étape de gravure est d'environ 3 secondes.
e) Une étape de passivation de la surface du substrat (la passivation est un processus sélectif qui s'effectue préférentiellement sur les zones du substrat exemptes de résine photosensible). L'étape de passivation est effectuée par la technique de gravure ionique réactive profonde (ou DRIE) du type Bosch à l'aide d'un gaz ionisé tel que l'octafluorobutène (C₄F₈). La durée de l'étape de passivation est d'environ 2 secondes
f) Une étape de répétition desdites étapes de gravure et de passivation afin d'obtenir ledit substrat microstructuré.

On notera que les étapes de gravure et de passivation sont effectuées à l'aide d'un appareil de gravure à plasma de la société SPTS®.

La répétition des étapes de gravure et de passivation permet d'obtenir des microstructures élémentaires présentant un rapport d'aspect important par exemple supérieur ou égal à 10 et de préférence compris entre 10 et 100. De plus, les microstructures élémentaires ainsi obtenues s'étendent en éloignement et orthogonalement du plan d'extension principal du substrat.
g) Une étape de retrait de la résine photosensible réalisée par une technique de traitement de surface par plasma par l'intermédiaire d'une machine commercialisée sous le nom Ashing System GIGAbatch 310 M par la société PVA TEPLA®.

On notera que cette technique de fabrication produit des microstructures élémentaires présentant des irrégularités telles que des stries à leur surface (plus particulièrement visibles aux figures 1c et 4c). L'étape g) de retrait de la résine photosensible est suivie par une étape de dépôt d'alumine (ou Al₂O₃) à la surface des microstructures élémentaires obtenues (réalisation non représentée). L'étape de dépôt d'alumine est effectuée par un procédé de dépôt par couches atomiques (ou ALD) et permet le dépôt d'une couche conforme d'alumine à l'intérieur et à l'extérieur des microstructures élémentaires.

Cette couche d'alumine comble au moins partiellement les stries produites par le procédé d'obtention du substrat microstructuré selon l'invention afin de faciliter le dépôt ultérieur d'autres matériaux à la surface du substrat microstructuré et d'isoler électriquement le substrat microstructuré selon l'invention.

La présente invention a pour dernier objet un dispositif de stockage d'énergie électrique, par exemple une batterie électrique, plus particulièrement une batterie 41 électrochimique tout solide qui comporte un substrat microstructuré 43 selon l'invention.

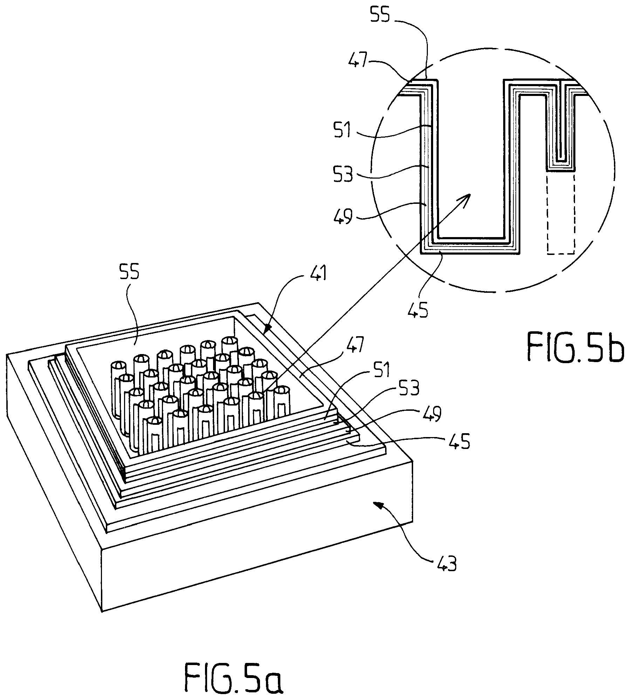

La figure 5a est une vue schématique en perspective de haut et partiellement arrachée d'une batterie électrochimique 41 selon l'invention.

Ladite batterie 41 comporte :
- un premier collecteur de courant 45 disposé sur le substrat microstructuré 43,
- un deuxième collecteur de courant 47,
- une électrode négative 49 et une électrode positive 51 disposées entre les premier 45 et deuxième 47 collecteurs de courant,
- un électrolyte 53 disposé entre l'électrode négative 49 et l'électrode positive 51.

Les éléments 45 à 53 ci-dessus se présentent sous la forme d'un empilement de couches minces réalisées dans des matériaux solides.

Les collecteurs de courant sont par exemple réalisés dans des matériaux solides tels que l'aluminium, le cuivre, le platine, le nitrure de titane.

De plus, une couche protectrice 55 par exemple de nitrure de silicium ou d'oxyde de silicium est déposée à la surface de l'empilement des couches minces 45 à 53 afin de protéger celles-ci de l'oxydation.

Comme illustré à la figure 5b, le substrat microstructuré selon l'invention permet le dépôt desdites couches minces 45 à 53 sur la totalité de la surface du substrat 43. Le substrat microstructuré 43 selon l'invention est apte à accueillir une plus grande quantité de matériaux d'électrodes tout en présentant de bonnes qualités mécaniques. Ainsi, la batterie 41 selon l'invention présente de meilleures performances que les batteries de l'art antérieur.

On note que les couches minces 45 à 53 sont réalisées à l'aide d'au moins une des méthodes suivantes : procédé de dépôt par couches atomiques (ou ALD), épitaxie par jet moléculaire (ou MBE), procédé de dépôt chimique en phase vapeur (CVD), procédé de dépôt physique en phase vapeur (PVD), procédé de dépôt électrolytique...

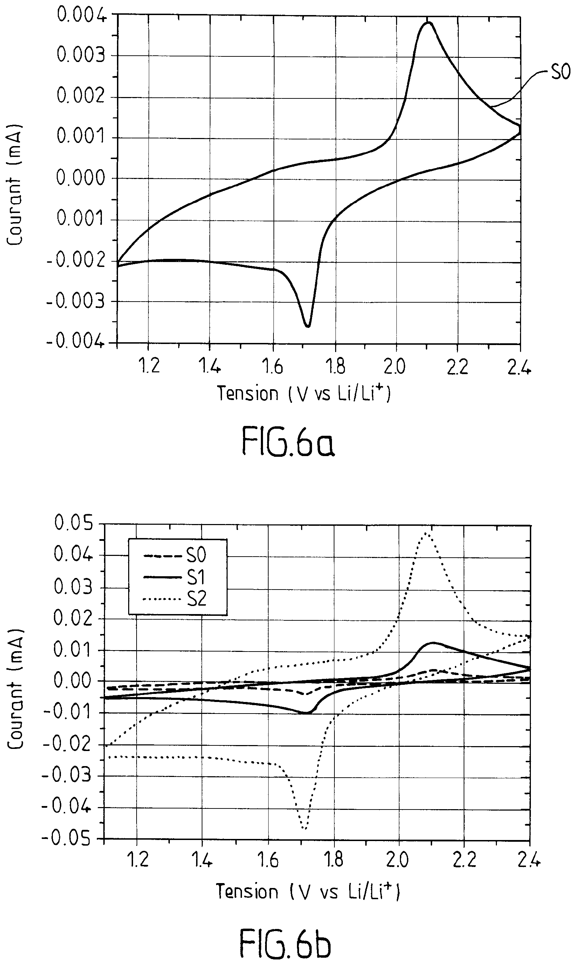

A titre d'exemple, les figures 6a à 6d illustrent les grandeurs caractéristiques de demi-cellules électrochimiques comportant un substrat microstructuré selon l'invention et/ou d'une demi-cellule électrochimique comportant un substrat plan.

Les demi-cellules électrochimiques comportent chacune une couche mince de 30 nm de platine formant collecteur de courant et une couche mince de dioxyde de titane (sous forme cristalline anatase) formant électrode négative qui présente une épaisseur comprise entre 38 nm et 150 nm.

Les demi-cellules électrochimiques ont été testées avec un électrolyte liquide qui est un mélange de bis(trifluoro-méthanesulfonyl)imidure de lithium (ou LiTFSI) de concentration 1M, de carbonate d'éthylène et de carbonate de diéthylène (en proportions volumiques identiques). De plus, ces demi-cellules ont été testées chacune avec une électrode en lithium, l'électrode de lithium jouant le rôle de contre-électrode et d'électrode de référence dans la cellule électrochimique ainsi formée (couple redox Li/Li⁺).

Les différentes demi-cellules électrochimiques S0 à S3 testées comportent des substrats présentant les caractéristiques présentées dans le tableau 1 ci-après :

**TABLEAU 1**

| | **OD** (µm) | **ID** (µm) | **SP** (µm) | **d_{L}** (µm) | **dᵢₙ** (µm) |
|---|---|---|---|---|---|
| **S0** | 0 | 0 | 0 | 0 | 0 |
| **S1** | 3 | 0 | 4 | 9,1 | 0 |
| **S2** | 2,02 | 1,25 | 4,04 | 27,6 | 13,8 |
| **S3** | 2 | 1,5 | 4 | 45 | 22,5 |

Les demi-cellules électrochimiques S0 et S1 comportent respectivement un substrat plan et un substrat microstructuré dans lequel les microstructures élémentaires sont des piliers.

Les demi-cellules électrochimiques S2 et S3 comportent, quant à elles, un substrat microstructuré selon l'invention.

On notera donc que le substrat microstructuré selon l'invention permet la fabrication de dispositifs de stockage d'énergie électrique qui comprennent une plus grande quantité de matériaux actifs dans chacun des éléments constitutifs (par exemple : électrolyte, électrodes...) d'un dispositif de stockage d'énergie électrique.

Les résultats des grandeurs caractéristiques mesurées pour les demi-cellules électrochimiques sont donc illustrés aux figures 6a à 6d.

La figure 6a représente l'intensité du courant en mA (ou milliampère) délivrée par la demi-cellule électrochimique S0 comportant un substrat plan en fonction de la tension en V (ou volts) appliquée aux bornes de la cellule électrochimique formée.

La figure 6b représente l'intensité du courant en mA délivrée par les cellules électrochimiques S0, S1 et S2, en fonction de la tension en V (ou volt) appliquée aux bornes desdites cellules électrochimiques formées.

On observe que l'intensité maximale du courant délivrée par la cellule comportant le substrat microstructuré selon l'invention S2 est :
- au moins 10 fois supérieure, à tension identique, à l'intensité du courant délivrée par la cellule comportant un substrat plan S0,
- au moins 4 fois supérieure, à tension identique, à l'intensité du courant délivrée par la cellule comportant un substrat microstructuré S1.

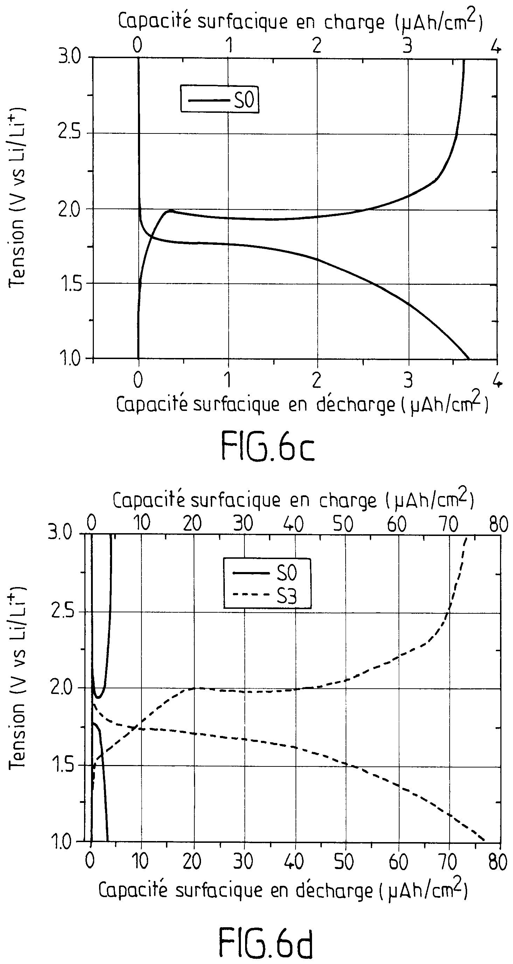

La figure 6c représente la capacité surfacique en µAh/cm² (ou microampère-heure par centimètre-carré) lors d'une charge et lors d'une décharge de la cellule électrochimique comportant un substrat plan S0, en fonction d'une tension en V appliquée aux bornes de ladite cellule.

La figure 6d représente la capacité surfacique en µAh/cm² lors d'une charge et lors d'une décharge de la cellule électrochimique comportant un substrat microstructuré selon l'invention S3, en fonction d'une tension en V appliquée aux bornes de ladite cellule.

La figure 6d inclut également les résultats illustrés à la figure 6c pour la cellule électrochimique comportant un substrat plan.

On observe que les valeurs maximales de la capacité surfacique de la cellule comportant un substrat microstructuré selon l'invention, que cela soit lors de la charge ou de la décharge de la cellule électrochimique, sont au moins 20 fois supérieures aux valeurs maximales de la capacité surfacique de la cellule électrochimique comportant un substrat plan.

On notera que les résultats illustrés aux figures 6a-b ont été obtenus avec une vitesse de balayage en tension de 0,15 mV/s.

Les figures 6a à 6d illustrent donc bien le fait que le dispositif de stockage d'énergie électrique selon l'invention permet d'obtenir de meilleures performances que les dispositifs de stockage d'énergie électrique de l'art antérieur.

## Revendications

1. Substrat microstructuré comportant une pluralité d'au moins une microstructure élémentaire, ladite au moins une microstructure élémentaire présentant une forme tubulaire avec des extrémités inférieure (3a) et supérieure (3b) longitudinales opposées, l'extrémité inférieure (3a) étant reliée au substrat, ladite au moins une microstructure élémentaire (3) définissant une cavité interne (5) ouverte au niveau de son extrémité supérieure (3b), ledit substrat microstructuré étant **caractérisé en ce qu'**il comporte une couche conforme d'alumine déposée à sa surface, à l'intérieur et à l'extérieur des microstructures élémentaire (3).

2. Substrat selon la revendication 1, **caractérisé en ce que** la microstructure élémentaire (3) présente une section transversale circulaire, elliptique, rectangulaire, carrée ou triangulaire.

3. Substrat selon la revendication 1 ou 2, **caractérisé en ce que** la microstructure élémentaire (3) présente une dimension longitudinale d_{L} comprise entre 5 et 200 µm et une dimension transversale OD comprise entre 2 et 10 µm.

4. Substrat selon l'une quelconque des revendications précédentes, **caractérisé en ce que** les microstructures élémentaires (3) du substrat sont disposées périodiquement sur ledit substrat (1).

5. Substrat selon la revendication 4, **caractérisé en ce que** les microstructures élémentaires (3) du substrat (1) présentent une période spatiale SP comprise entre 3 et 10 µm.

6. Substrat selon l'une quelconque des revendications précédentes, **caractérisé en ce que** la cavité (5) ouverte de chacune des microstructures élémentaires (3) s'étend longitudinalement à l'intérieur de ladite microstructure élémentaire.

7. Substrat selon l'une quelconque des revendications précédentes, **caractérisé en ce que** la microstructure élémentaire (3) présente un rapport d'aspect rₐₛp supérieur ou égal à 10.

8. Substrat selon l'une quelconque des revendications précédentes, **caractérisé en ce qu'**il est réalisé dans un matériau choisi parmi le silicium, le dioxyde de silicium, l'arséniure de gallium, le nitrure de silicium et le phosphure d'indium.

9. Procédé d'obtention d'un substrat microstructuré tel que défini à l'une quelconque des revendications précédentes par microstructuration d'un substrat comportant une surface plane, **caractérisé en ce qu'**il comporte au moins les étapes suivantes :
a) une étape d'enduction d'une couche de résine photosensible sur la surface plane dudit substrat ;
b) une étape de réalisation par photolithographie d'une répétition d'au moins un motif élémentaire de forme annulaire dans la couche de résine photosensible afin que la surface du substrat présente des zones exemptes de résine photosensible ;
c) une étape de gravure des zones de la surface du substrat exemptes de résine photosensible ;
d) une étape de passivation de la surface du substrat ;
e) une étape de répétition desdites étapes de gravure c) et de passivation d) afin d'obtenir ledit substrat microstructuré, et, postérieurement à l'étape de répétition e), une étape de dépôt d'une couche conforme d'alumine à la surface du substrat microstructuré, à l'intérieur et à l'extérieur des microstructures élémentaires (3).

10. Procédé selon la revendication 9, **caractérisé en ce que** le motif élémentaire obtenu lors de l'étape de photolithographie b) présente une forme annulaire dont les dimensions coïncident avec les dimensions transversales (SP, FP, ID) de la microstructure élémentaire (3).

11. Procédé selon la revendication 9 ou 10, **caractérisé en ce que** les étapes de gravure c) et de passivation d) sont réalisées par l'intermédiaire d'un gaz ionisé.

12. Utilisation d'un substrat microstructuré tel que défini à l'une quelconque des revendications 1 à 8 pour l'élaboration d'un dispositif de stockage d'énergie électrique.

13. Dispositif de stockage d'énergie électrique comportant au moins :
- un substrat (43),
- une électrode négative (49) et une électrode positive (51) dont l'une est disposée sur le substrat (43),
- un électrolyte (53) disposé entre l'électrode négative (49) et l'électrode positive (51),
**caractérisé en ce que** le substrat (43) est un substrat microstructuré selon l'une quelconques des revendications 1 à 8.

14. Dispositif selon la revendication 13, **caractérisé en ce qu'**il comprend en outre un premier collecteur de courant (45) disposé sur le substrat (43), un deuxième collecteur de courant (47), l'électrode négative (49) et l'électrode positive (51) étant disposées entre les premier (45) et deuxième (47) collecteurs de courant.

15. Dispositif selon la revendication 14, **caractérisé en ce que** le substrat (43) est réalisé dans un matériau choisi parmi le silicium, le dioxyde de silicium, l'arséniure de gallium, le nitrure de silicium et le phosphure d'indium et **en ce que** les collecteurs de courant (45,47) sont réalisés dans des matériaux solides choisis parmi l'aluminium, le cuivre, le platine et le nitrure de titane.

16. Dispositif de stockage d'énergie électrique selon l'une des revendications 13 à 15, **caractérisé en ce que** l'électrode négative (49), l'électrode positive (51) et l'électrolyte (53) se présentent chacun sous la forme d'une couche mince.

## Patentansprüche

1. Mikrostrukturiertes Substrat, aufweisend eine Vielzahl mindestens einer elementaren Mikrostruktur, wobei die mindestens eine elementare Mikrostruktur (3) eine rohrförmige Form mit gegenüberliegendem unteren (3a) und oberen (3b) länglichen Ende aufweist, wobei das untere Ende (3a) mit dem Substrat verbunden ist, wobei die mindestens eine elementare Mikrostruktur (3) einen inneren Hohlraum (5) aufweist, der im Bereich seines oberen Endes (3b) offen ist, wobei das mikrostrukturierte Substrat **dadurch gekennzeichnet ist, dass** es eine alumiumoxidkonforme Schicht aufweist, die auf seiner Oberfläche innerhalb und außerhalb der elementaren Mikrostrukturen (3) aufgebracht ist.

2. Substrat nach Anspruch 1, **dadurch gekennzeichnet, dass** die elementare Mikrostruktur (3) einen kreisförmigen, elliptischen, rechteckigen, quadratischen oder dreieckigen Querschnitt aufweist.

3. Substrat nach Anspruch 1 oder 2, **dadurch gekennzeichnet, dass** die elementare Mikrostruktur (3) eine Längsdimension d_{L} zwischen 5 und 200 µm inklusive und eine Querdimension OD zwischen 2 und 10 µm inklusiv aufweist.

4. Substrat nach einem der vorangehenden Ansprüche, **dadurch gekennzeichnet, dass** die elementaren Mikrostrukturen (3) des Substrats periodisch auf dem Substrat (1) angeordnet sind.

5. Substrat nach Anspruch 4, **dadurch gekennzeichnet, dass** die elementaren Mikrostrukturen (3) des Substrats (1) eine räumliche Periode SP zwischen 3 und 10 µm inklusive aufweisen.

6. Substrat nach einem der vorangehenden Ansprüche, **dadurch gekennzeichnet, dass** sich der offene Hohlraum (5) jeder der elementaren Mikrostrukturen (3) längs im Innern der elementaren Mikrostruktur erstreckt.

7. Substrat nach einem der vorangehenden Ansprüche, **dadurch gekennzeichnet, dass** die elementare Mikrostruktur (3) ein Seitenverhältnis rₐₛp größer oder gleich 10 aufweist.

8. Substrat nach einem der vorangehenden Ansprüche, **dadurch gekennzeichnet, dass** es aus einem Material hergestellt ist, das aus dem Silicium, dem Siliciumdioxid, dem Galliumarsenid, dem Siliciumnitrid und dem Indiumphosphid ausgewählt ist.

9. Verfahren für die Herstellung eines mikrostrukturierten Substrats nach einem der vorangehenden Ansprüche durch Mikrostrukturierung eines Substrats, das eine ebene Oberfläche aufweist, **dadurch gekennzeichnet, dass** es mindestens die folgenden Schritte umfasst:
a) einen Schritt des Beschichtens mit einer photosensiblen Harzschicht auf der ebenen Oberfläche des Substrats,
b) einen Schritt der Herstellung durch Photolithographie einer Wiederholung von mindestens einem elementaren Motiv ringförmiger Form in der photosensiblen Harzschicht, damit die Oberfläche des Substrats Zonen ohne photosensibles Harz aufweist,
c) einen Gravurschritt der Zonen der Oberfläche des Substrats ohne photosensibles Harz,
d) einen Passivierungsschritt der Oberfläche des Substrats,
e) einen Wiederholungsschritt der Schritte der Gravur c) und der Passivierung d), um das mikrostrukturierte Substrat zu erhalten, und nach dem Wiederholungsschritt e) einen Schritt des Auftragens einer Aluminiumoxidschicht auf der Oberfläche des mikrostrukturierten Substrats innerhalb und außerhalb der elementaren Mikrostrukturen (3).

10. Verfahren nach Anspruch 9, **dadurch gekennzeichnet, dass** das beim Photolithographieschritt b) erhaltene elementare Motiv eine ringförmige Form aufweist, deren Dimensionen mit den transversalen Dimensionen (SP, FP, ID) der elementaren Mikrostruktur (3) übereinstimmen.

11. Verfahren nach Anspruch 9 oder 10, **dadurch gekennzeichnet, dass** die Schritte der Gravur c) und der Passivierung d) mit Hilfe eines ionisierten Gases durchgeführt werden.

12. Verwendung eines mikrostrukturierten Substrats nach einem der Ansprüche 1 bis 8 für die Herstellung einer Vorrichtung zum Speichern elektrischer Energie.

13. Vorrichtung zum Speichern elektrischer Energie, die mindestens aufweist:
- ein Substrat (43),
- eine negative Elektrode (49) und eine positive Elektrode (51), von denen eine auf dem Substrat (43) angeordnet ist,
- einen Elektrolyt (53), der zwischen der negativen Elektrode (49) und der positiven Elektrode (51) angeordnet ist,
**dadurch gekennzeichnet, dass** das Substrat (43) ein mikrostrukturiertes Substrat nach einem der Ansprüche 1 bis 8 ist.

14. Vorrichtung nach Anspruch 13, **dadurch gekennzeichnet, dass** sie ferner einen ersten Stromsammler (45), der auf dem Substrat (43) angeordnet ist, einen zweiten Stromsammler (47) umfasst, wobei die negative Elektrode (49) und die positive Elektrode (51) zwischen dem ersten (45) und zweiten (47) Stromsammler angeordnet sind.

15. Vorrichtung nach Anspruch 14, **dadurch gekennzeichnet, dass** das Substrat (43) aus einem Material hergestellt ist, das aus dem Silicium, dem Siliciumdioxid, dem Galliumarsenid, dem Siliciumnitrid und dem Indiumphosphid ausgewählt ist und dass die Stromsammler (45, 47) aus festen Materialien hergestellt sind, die aus dem Aluminium, dem Kupfer, dem Platin und dem Titannitrid ausgewählt sind.

16. Vorrichtung zum Speichern elektrischer Energie nach einem der Ansprüche 13 bis 15, **dadurch gekennzeichnet, dass** die negative Elektrode (49), die positive Elektrode (51) und der Elektrolyt (53) jeweils in Form einer Dünnschicht vorliegen.

## Claims

1. A microstructured substrate including a plurality of at least one elementary microstructure, said at least one elementary microstructure having a tubular shape with lower (3a) and upper (3b) opposite longitudinal ends, the lower end (3a) being connected to the substrate, said at least one elementary microstructure (3) defining an inner cavity (5) open at its upper end (3b), said microstructured substrate being **characterized in that** it includes a conformal layer of alumina deposited on its surface, inside and outside the elementary microstructures (3).

2. The substrate according to claim 1, **characterized in that** the elementary microstructure (3) has a circular, elliptical, rectangular, square or triangular transverse cross section.

3. The substrate according to claim 1 or 2, **characterized in that** the elementary microstructure (3) has a longitudinal dimension d_{L} comprised between 5 and 200 µm and a transverse dimension OD comprised between 2 and 10 µm.

4. The substrate according to any one of the preceding claims, **characterized in that** the elementary microstructures (3) of the substrate are arranged periodically over said substrate (1).

5. The substrate according to claim 4, **characterized in that** the elementary microstructures (3) of the substrate (1) have a spatial period SP comprised between 3 and 10 µm.

6. The substrate according to any one of the preceding claims, **characterized in that** the open cavity (5) of each of the elementary microstructures (3) extends longitudinally inside said elementary microstructure.

7. The substrate according to any one of the preceding claims, **characterized in that** the elementary microstructure (3) has an aspect ratio rₐₛₚ higher than or equal to 10.

8. The substrate according to any one of the preceding claims, **characterized in that** it is made from a material chosen from silicon, silicon dioxide, gallium arsenide, silicon nitride and indium phosphide.

9. A process for obtaining a microstructured substrate as defined in any one of the preceding claims by microstructuring a substrate having a planar surface, **characterized in that** it includes at least the following steps:
a) a step of coating a photoresist layer onto the planar surface of said substrate;
b) a step of producing, by photolithography, a repetition of at least one annular elementary pattern in the photoresist layer in order that the surface of the substrate presents zones free from photoresist,
c) a step of etching the zones of the surface of the substrate free from photoresist,
d) a step of passivating the surface of the substrate,
e) a step of repeating said etching and passivating steps c) and d) in order to obtain said microstructured substrate, and, subsequently to the repeating step e), a step of depositing a conformal layer of alumina on the surface of the microstructured substrate, inside and outside the elementary microstructures.

10. The process according to claim 9, **characterized in that** the elementary pattern obtained in the photolithography step b) has an annular shape, the dimensions of which coincide with the transverse dimensions (SP, FP, ID) of the elementary microstructure (3).

11. The process according to claim 9 or 10, **characterized in that** the etching and passivating steps c) and d) are carried out by way of an ionized gas.

12. A use of a microstructured substrate such as defined in any one of claims 1 to 8 to produce a device for storing electrical energy.

13. A device for storing electrical energy including at least:
- a substrate (43),
- a negative electrode (49) and a positive electrode (51), one of which is placed on the substrate (43),
- an electrolyte (53) placed between the negative electrode (49) and the positive electrode (51),
**characterized in that** the substrate (43) is a microstructured substrate according to any one of claims 1 to 8.

14. The device according to claim 13, **characterized in that** it furthermore comprises a first current collector (45) placed on the substrate (43) and a second current collector (47), the negative electrode (49) and the positive electrode (51) being placed between the first (45) and second (47) current collectors.

15. The device according to claim 14, **characterized in that** the substrate (43) is made from a material chosen from silicon, silicon dioxide, gallium arsenide, silicon nitride and indium phosphide and **in that** the current collectors (45, 47) are made from solid materials chosen from aluminum, copper, platinum and titanium nitride.

16. The device for storing electrical energy according to one of claims 13 to 15, **characterized in that** the negative electrode (49), the positive electrode (51) and the electrolyte (53) each take the form of a thin layer.
